# EUROPEAN PATENT APPLICATION

(11) **EP 2 782 137 A1**
(43) Date of publication of application: **24.09.2014**
(21) Application number: 12849942.3
(22) Date of filing: 26.09.2012
(51) Int. Cl.: H01L 29/12, H01L 21/336, H01L 29/78

(54) **METHOD FOR MANUFACTURING SEMICONDUCTOR DEVICE, AND SEMICONDUCTOR DEVICE**

(30) Priority: 16.11.2011 JP 2011250256
(71) Applicant: Sumitomo Electric Industries, Ltd., Osaka-shi, Osaka 541-0041 (JP)
(72) Inventor: MASUDA, Takeyoshi, Osaka-shi Osaka 554-0024 (JP); WADA, Keiji, Osaka-shi Osaka 554-0024 (JP); HIYOSHI, Toru, Osaka-shi Osaka 554-0024 (JP)
(74) Representative: Grünecker, Kinkeldey, Stockmair & Schwanhäusser
(86) International application number: PCT/JP2012/074661
(87) International publication number: WO 2013/073293

(57) **Abstract**

A method for manufacturing a semiconductor device includes the steps of: preparing a substrate (30) made of silicon carbide; forming, in the substrate (30), a trench (15) opened on one main surface (30A) side of the substrate (30); and forming an oxide film (40) in a region including a surface of the trench (15). In the step of forming the oxide film (40), the substrate (30) is heated at a temperature of not less than 1250°C in an atmosphere containing oxygen.

## Description

### TECHNICAL FIELD

The present invention relates to a method for manufacturing a semiconductor device, and a semiconductor device. More particularly, the present invention relates to a method for manufacturing a semiconductor device capable of stably manufacturing a semiconductor device having desired characteristics, and a semiconductor device capable of stably exhibiting a desired withstanding voltage by alleviating electric field concentration on an oxide film.

### BACKGROUND ART

In recent years, in order to achieve a high breakdown voltage, low loss, and the like of semiconductor devices, silicon carbide has begun to be adopted as a material for a semiconductor device. Silicon carbide is a wide band gap semiconductor having a band gap larger than that of silicon, which has been conventionally widely used as a material for semiconductor devices. Hence, by adopting silicon carbide as a material for a semiconductor device, the semiconductor device can have a high breakdown voltage, a reduced on-resistance, and the like.

As a semiconductor device adopting silicon carbide as a material, for example, a MOSFET (Metal Oxide Semiconductor Field Effect Transistor) is used. For the MOSFET, a trench gate-type device structure has also increasingly been adopted to miniaturize a cell and further reduce the on-resistance, and improvement in characteristics thereof and the like have been under examination (see, for example, Japanese Patent Laying-Open No. 7-326755 (Patent Literature 1)). Patent Literature I proposes a method for manufacturing a trench gate-type MOSFET having a low threshold voltage and a high withstanding voltage by forming an oxide film with a thin film thickness on a trench side wall surface and forming an oxide film with a thick film thickness on a trench bottom surface.

### CITATION LIST

### PATENT LITERATURE

PTL 1: Japanese Patent Laying-Open No. 7-326755

### SUMMARY OF INVENTION

### TECHNICAL PROBLEM

In the manufacturing method proposed in Patent Literature 1, the MOSFET having a low threshold voltage and a high withstanding voltage can be manufactured by adopting a crystal plane with a slow oxidation rate as the trench side wall surface and adopting a crystal plane with a fast oxidation rate as the trench bottom surface, and utilizing dependency of the oxidation rate on plane orientation.

However, in the manufacturing method, for example, if there are variations in plane orientation of the trench side wall surface or the trench bottom surface, the formed oxide film also has variations in its film thickness due to the dependency of the oxidation rate on the plane orientation. The variations in the film thickness of the oxide film also affects characteristics of the manufactured MOSFET. As a result, it becomes difficult to stably manufacture a MOSFET having desired characteristics.

The present invention has been made in view of the aforementioned problem, and one object of the present invention is to provide a method for manufacturing a semiconductor device capable of stably manufacturing a semiconductor device having desired characteristics, and a semiconductor device capable of stably exhibiting a desired withstanding voltage by alleviating electric field concentration on an oxide film.

### SOLUTION TO PROBLEM

A method for manufacturing a semiconductor device in accordance with the present invention includes the steps of: preparing a substrate made of silicon carbide; forming, in the substrate, a trench opened on one main surface side of the substrate; and forming an oxide film in a region including a surface of the trench. In the step of forming the oxide film, the substrate is heated at a temperature of not less than 1250°C in an atmosphere containing oxygen.

The inventor of the present invention conducted detailed studies on a measure for stably manufacturing a semiconductor device having desired characteristics. As a result, the inventor has found that dependency of an oxidation rate on plane orientation in a substrate can be reduced by setting a heating temperature for the substrate in the formation of an oxide film serving as a gate insulating film to be higher than a typical heating temperature, specifically, to not less than 1250°C, and has arrived at the present invention. In the method for manufacturing a semiconductor device in accordance with the present invention, the oxide film is formed in the region including the surface of the trench formed in the substrate, by heating the substrate at an appropriate temperature of not less than 1250°C. Thereby, dependency of a film thickness of the formed oxide film on plane orientation of the surface of the trench is reduced. As a result, even if there are variations in the plane orientation of the surface of the trench, the oxide film having a film thickness close to a desired film thickness can be formed. Thus, according to the method for manufacturing a semiconductor device in accordance with the present invention, a semiconductor device having desired characteristics such as a threshold voltage can be stably manufactured by stably forming the oxide film having a desired film thickness in the region including the surface of the trench.

In the method for manufacturing a semiconductor device, in the step of forming the oxide film, the substrate may be heated at a temperature of not less than 1300°C. Thereby, the dependency of the film thickness of the formed oxide film on the plane orientation of the surface of the trench can be reduced further effectively.

In the method for manufacturing a semiconductor device, in the step of forming the oxide film, the substrate may be heated at a temperature of not more than 1400°C. Thus, the method for manufacturing a semiconductor device can be performed at an appropriate temperature of not more than 1400°C which considers durability of manufacturing equipment and the like.

The method for manufacturing a semiconductor device may further include the step of introducing nitrogen atoms into a region including an interface between the oxide film and the silicon carbide constituting the substrate, by heating the substrate in an atmosphere including a gas containing nitrogen atoms.

Thereby, an interface state existing in the region including the interface between the oxide film and the silicon carbide constituting the substrate can be reduced. Accordingly, a reduction in channel mobility due to the existence of the interface state can be suppressed.

In the method for manufacturing a semiconductor device, the main surface of the substrate may be a {0001} plane. Silicon carbide can be readily grown in a <0001> direction. Therefore, the substrate can be readily prepared by using the {0001} plane as the main surface of the substrate made of silicon carbide. It is noted that the state where the main surface is the {0001} plane refers to a state where the main surface has an off angle of not more than 8° with respect to the {0001} plane.

In the method for manufacturing a semiconductor device, in the step of forming the trench, the trench including a wall surface having an angle of 40° to 70° with respect to a {0001} plane may be formed. Thus, a semiconductor device having high channel mobility can be manufactured by forming the trench including the wall surface having an angle within the above range with respect to the {0001} plane and forming a channel region along the wall surface.

A semiconductor device in accordance with the present invention includes a substrate made of silicon carbide and having a trench opened on one main surface side formed therein; and an oxide film formed to cover a surface of the trench. A maximum value of a film thickness of the oxide film is not more than twice a minimum value of the film thickness of the oxide film. It is noted that the film thickness of the oxide film refers to a film thickness thereof in a direction perpendicular to the surface of the trench.

According to the semiconductor device in accordance with the present invention, a semiconductor device capable of stably exhibiting a desired withstanding voltage by alleviating electric field concentration on an oxide film can be provided.

### ADVANTAGEOUS EFFECTS OF INVENTION

As is clear from the above description, according to the method for manufacturing a semiconductor device in accordance with the present invention, a semiconductor device having desired characteristics can be stably manufactured. In addition, according to the semiconductor device in accordance with the present invention, a semiconductor device capable of stably exhibiting a desired withstanding voltage by alleviating electric field concentration on an oxide film can be provided.

### BRIEF DESCRIPTION OF DRAWINGS

Fig. 1 is a schematic cross sectional view showing a configuration of a MOSFET.
Fig. 2 is a flowchart schematically showing a method for manufacturing the MOSFET.
Fig. 3 is a schematic cross sectional view for illustrating the method for manufacturing the MOSFET.
Fig. 4 is a schematic cross sectional view for illustrating the method for manufacturing the MOSFET.
Fig. 5 is a schematic cross sectional view for illustrating the method for manufacturing the MOSFET.
Fig. 6 is a schematic cross sectional view for illustrating the method for manufacturing the MOSFET.
Fig. 7 is a schematic cross sectional view for illustrating the method for manufacturing the MOSFET.
Fig. 8 is a schematic cross sectional view for illustrating the method for manufacturing the MOSFET.
Fig. 9 is a schematic cross sectional view for illustrating the method for manufacturing the MOSFET.
Fig. 10 is an electron microscope photograph showing a film thickness of an oxide film.
Fig. 11 is a view showing influence of a heating temperature for a substrate on the film thickness of the oxide film.
Fig. 12 is a view showing influence of the heating temperature for the substrate on a film thickness ratio of the oxide film.

### DESCRIPTION OF EMBODIMENTS

Hereinafter, an embodiment of the present invention will be described with reference to the drawings. It should be noted that in the below-mentioned drawings, the same or corresponding portions are given the same reference characters and are not described repeatedly. Further, in the present specification, an individual orientation is represented by [], a group orientation is represented by <>, an individual plane is represented by (), and a group plane is represented by { } . In addition, a negative index is supposed to be crystallographically indicated by putting "-" (bar) above a numeral, but is indicated by putting the negative sign before the numeral in the present specification.

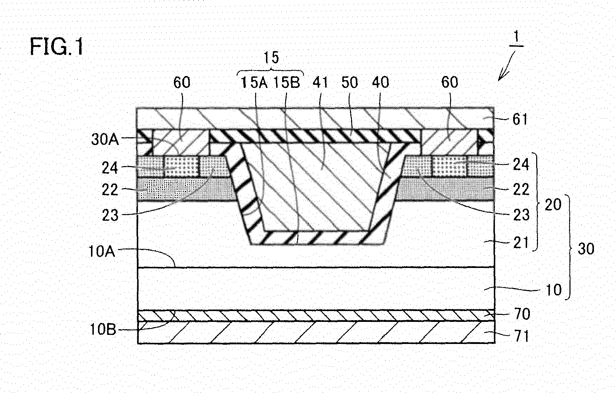

Firstly, a configuration of a semiconductor device in accordance with one embodiment of the present invention will be described. Referring to Fig. 1, a MOSFET 1 as the semiconductor device in accordance with the present embodiment includes a silicon carbide substrate 10, a silicon carbide layer 20, an oxide film 40, a gate electrode 41, an interlayer insulating film 50, a source electrode 60, a drain electrode 70, a source wire 61, and a backside surface protecting electrode 71. Silicon carbide layer 20 includes a drift region 21, a body region 22, a source region 23, and a contact region 24. Silicon carbide substrate 10 and silicon carbide layer 20 constitute a substrate 30 made of silicon carbide. Thus, MOSFET 1 as the semiconductor device in accordance with the present embodiment is a silicon carbide semiconductor device including substrate 30 made of silicon carbide.

In substrate 30, a trench 15 opened on one main surface 30A side is formed. Trench 15 includes side wall surfaces 15A and a bottom surface 15B, and is formed such that each side wall surface 15A penetrates source region 23 and body region 22 to extend over source region 23, body region 22, and drift region 21, and bottom surface 15B is positioned in drift region 21.

Silicon carbide substrate 10 has n type conductivity because it contains an n type impurity. Drift region 21 is formed on a main surface 10A of silicon carbide substrate 10. Drift region 21 has n type conductivity because it contains an n type impurity. The n type impurity contained in drift region 21 has a concentration value lower than that of the n type impurity contained in silicon carbide substrate 10.

Body region 22 is formed on a side of drift region 21 opposite to its side facing silicon carbide substrate 10. Body region 22 is formed to include side wall surface 15A, and to extend in a direction away from side wall surface 15A while being in contact with drift region 21. Body region 22 has p type conductivity because it contains a p type impurity. The p type impurity contained in body region 22 is, for example, Al (aluminum), B (boron), or the like.

Source region 23 is formed on a side of body region 22 opposite to its side facing drift region 21. Source region 23 is formed to include side wall surface 15A, and to extend in the direction away from side wall surface 15A while being in contact with body region 22. Source region 23 has n type conductivity because it contains an n type impurity. The n type impurity contained in source region 23 has a concentration value higher than that of the n type impurity contained in drift region 21. The n type impurity contained in source region 23 is, for example, P (phosphorus) or the like.

Contact region 24 is formed to be adjacent to source region 23 while being in contact with body region 22. Contact region 24 has p type conductivity because it contains a p type impurity. The p type impurity contained in contact region 24 has a concentration value higher than that of the p type impurity contained in body region 22. The p type impurity contained in contact region 24 is, for example, Al, B, or the like, as with the p type impurity contained in body region 22.

Oxide film 40 is formed to cover a surface of trench 15, that is, side wall surfaces 15A and bottom surface 15B, and main surface 30A of substrate 30. A maximum value of a film thickness of oxide film 40 is not more than twice a minimum value of the film thickness of oxide film 40. Oxide film 40 is made of, for example, silicon dioxide (SiO₂).

Gate electrode 41 is formed within trench 15 to be in contact with oxide film 40 formed to cover side wall surfaces 15A and bottom surface 15B. Gate electrode 41 is made of, for example, a conductor such as polysilicon doped with an impurity, or Al.

Source electrode 60 is formed to be in contact with source region 23 and contact region 24. Source electrode 60 is made of a material that can make ohmic contact with source region 23, for example, NiₓSi_{y} (nickel silicide), TiₓSi_{y} (titanium silicide), AlₓSi_{y} (aluminum silicide), TiₓAl_{y}Si_{z} (titanium aluminum silicide), or the like, and is electrically connected to source region 23.

Interlayer insulating film 50 is formed to surround gate electrode 41 together with oxide film 40, and electrically isolates gate electrode 41 from source electrode 60 and source wire 61. Interlayer insulating film 50 is made of, for example, silicon dioxide (SiO₂).

Source wire 61 is formed to cover interlayer insulating film 50 and source electrode 60. Source wire 61 is made of, for example, a conductor such as Al, and is electrically connected with source region 23 via source electrode 60.

Drain electrode 70 is formed on a main surface 10B of silicon carbide substrate 10 opposite to its surface facing drift region 21. Drain electrode 70 is made of a material that can make ohmic contact with silicon carbide substrate 10, for example, the same material as that for source electrode 60, and is electrically connected with silicon carbide substrate 10. Backside surface protecting electrode 71 is formed to cover drain electrode 70. Backside surface protecting electrode 71 is made of, for example, a conductor such as Al.

Next, an operation of MOSFET 1 will be described. Referring to Fig. 1, in a state where a voltage applied to gate electrode 41 is less than a threshold voltage, that is, in an OFF state, even if a voltage is applied to between source electrode 60 and drain electrode 70, pn junction formed between body region 22 and drift region 21 is reverse-biased, and thus a non-conductive state is obtained. On the other hand, when a voltage equal to or higher than the threshold voltage is applied to gate electrode 41, an inversion layer is formed in a channel region as a region of body region 22 in contact with side wall surface 15A. As a result, source region 23 and drift region 21 are electrically connected to each other, and a current flows between source electrode 60 and drain electrode 70. MOSFET 1 is thus operated.

As described above, in MOSFET 1 as the semiconductor device in accordance with the present embodiment, the maximum value of the film thickness of oxide film 40 is not more than twice the minimum value of the film thickness of oxide film 40. This can alleviate electric field concentration on oxide film 40 formed to cover the surface of trench 15, more specifically, oxide film 40 formed to cover the vicinity of a boundary between each side wall surface 15A and bottom surface 15B where electric field concentration is likely to occur. Therefore, according to MOSFET 1 as the semiconductor device in accordance with the present embodiment, a semiconductor device capable of stably exhibiting a desired withstanding voltage can be provided.

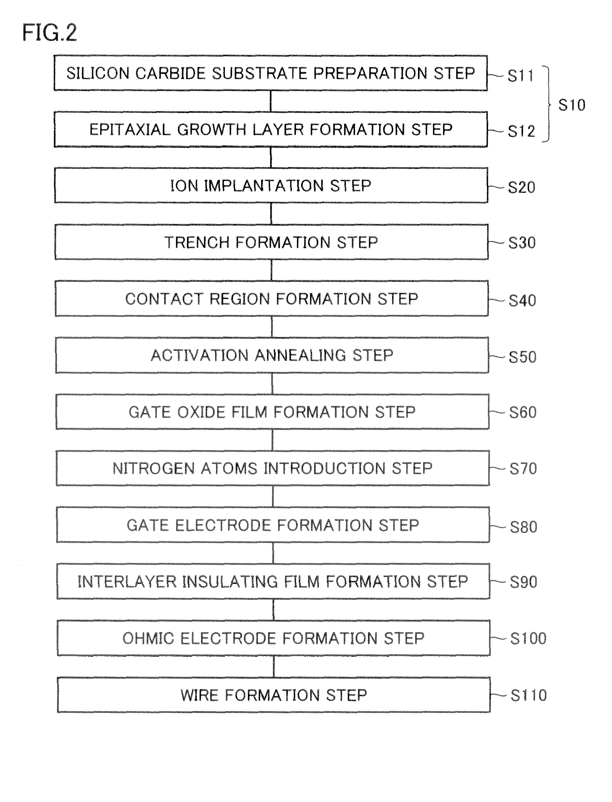

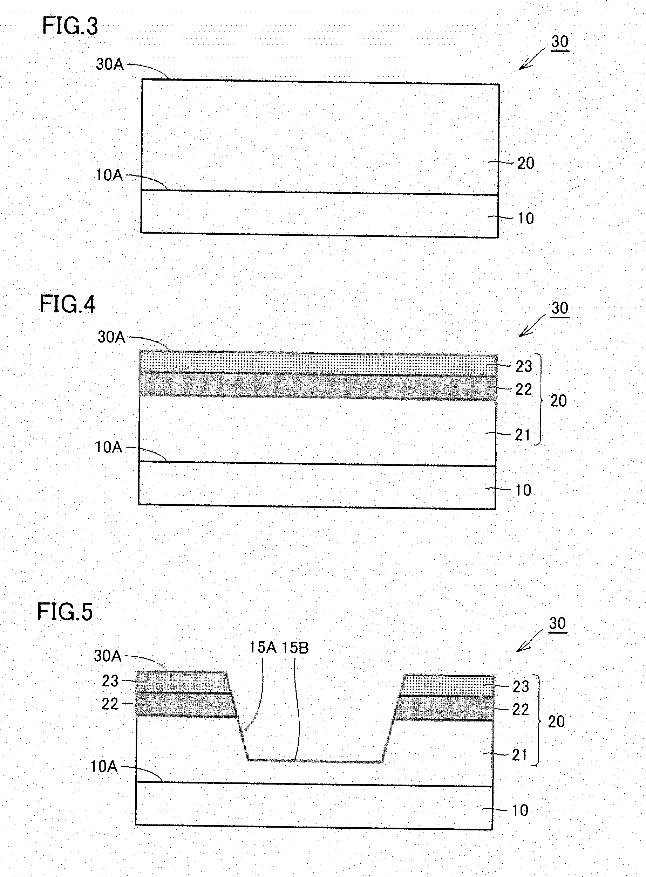

Next, a method for manufacturing a semiconductor device in accordance with one embodiment of the present invention will be described with reference to Figs. 2 to 9. In the method for manufacturing a semiconductor device in accordance with the present embodiment, MOSFET 1 (see Fig. 1) as the semiconductor device in accordance with the present embodiment is manufactured. Firstly, the step of preparing a substrate made of silicon carbide is performed as a step (S10). This step (S10) includes steps (S11) and (S12) described below. Firstly, a silicon carbide substrate preparation step is performed as a step (S11). In this step (S11), referring to Fig. 3, silicon carbide substrate 10 is prepared. Silicon carbide substrate 10 is made of, for example, 4H hexagonal silicon carbide.

Next, an epitaxial growth layer formation step is performed as a step (S12). In this step (S12), referring to Fig. 3, silicon carbide layer 20 is formed on main surface 10A of silicon carbide substrate 10 by epitaxial growth. Thereby, substrate 30 constituted by silicon carbide substrate 10 and silicon carbide layer 20 is prepared.

Main surface 30A of substrate 30 may be a {0001} plane. Silicon carbide can be readily grown in a <0001> direction. Therefore, substrate 30 can be readily prepared by using the {0001} plane as main surface 30A of substrate 30 made of silicon carbide.

Next, an ion implantation step is performed as a step (S20). In this step (S20), referring to Fig. 4, for example, Al ions are implanted into a surface layer portion of silicon carbide layer 20. Then, for example, P ions are implanted into the surface layer portion of silicon carbide layer 20 with an implantation depth shallower than that of the Al ions. Thereby, source region 23 having the P ions implanted therein and body region 22 having the Al ions implanted therein are formed in the surface layer portion of silicon carbide layer 20. A region of silicon carbide layer 20 where source region 23 and body region 22 are not formed serves as drift region 21.

Next, a trench formation step is performed as a step (S30). In this step (S30), referring to Fig. 5, trench 15 opened on one main surface 30A side of substrate 30 is formed in substrate 30. Specifically, trench 15 is formed such that each side wall surface 15A penetrates source region 23 and body region 22 to extend over source region 23, body region 22, and drift region 21, and bottom surface 15B is positioned in drift region 21.

In this step (S30), trench 15 may be formed in substrate 30 by an etching method including dry etching such as RIE (Reactive Ion Etching), thermal etching using a halogen-based gas such as chlorine gas, or a combination thereof. Specifically, trench 15 may be formed in substrate 30 by, for example, forming a mask layer (not shown) made of silicon dioxide (SiO₂) on main surface 30A of substrate 30, performing preliminary etching by RIE, and further performing thermal etching. Further, in this step (S30), variations in plane orientations of side wall surfaces 15A facing each other can be reduced by forming trench 15 in substrate 30 using the etching method including thermal etching. As a result, variations in the film thickness of the oxide film formed in a region including side wall surfaces 15A in a gate oxide film formation step (S60) described later can be reduced.

Further, in this step (S30), trench 15 may be formed such that an angle formed between side wall surface 15A and the {0001} plane is not less than 40° and not more than 70°. Thus, MOSFET 1 (see Fig. 1) having high channel mobility can be manufactured by forming trench 15 including side wall surface 15A having an angle within the above range with respect to the {0001} plane and forming the channel region along side wall surface 15A.

Further, in this step (S30), although trench 15 may be formed as a U-type trench including side wall surfaces 15A and bottom surface 15B, trench 15 is not limited thereto. For example, trench 15 may be formed as a V-type trench not including bottom surface 15B and including side wall surfaces 15A only.

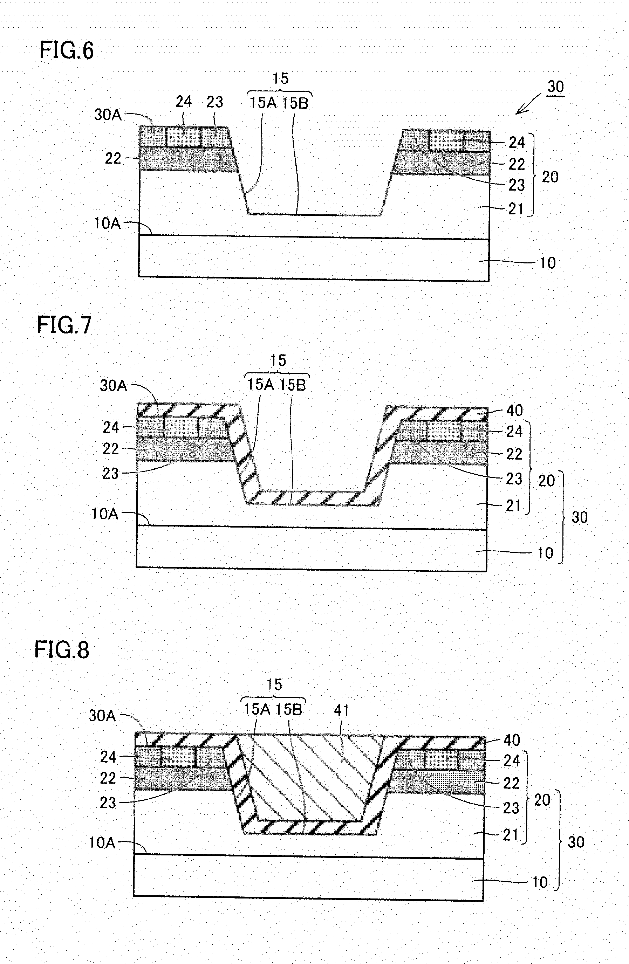

Next, a contact region formation step is performed as a step (S40). In this step (S40), referring to Fig. 6, contact region 24 that is adjacent to source region 23 while being in contact with body region 22 is formed by implanting, for example, Al ions into source region 23.

Next, an activation annealing step is performed as a step (S50). In this step (S50), the impurities introduced in the steps (S20) and (S40) are activated by heating substrate 30. Thereby, desired carriers are generated in the regions having the impurities introduced therein.

Next, a gate oxide film formation step is performed as a step (S60). In this step (S60), referring to Fig. 7, oxide film 40 is formed to extend over a region including the surface of trench 15, that is, side wall surfaces 15A and bottom surface 15B, and main surface 30A of substrate 30, by heating substrate 30 in an atmosphere containing oxygen. As oxide film 40, for example, an oxide film made of silicon dioxide (SiO₂) is formed. The atmosphere containing oxygen may be an atmosphere containing oxygen gas only, or may be an atmosphere containing a mixed gas of a noble gas such as argon and oxygen gas, or containing an oxidized gas such as N₂O, NO, NO₂, POCl₃, SO₂, and SO₄.

In this step (S60), substrate 30 is heated at a temperature of not less than 1250°C. Preferably, substrate 30 is heated at a temperature of not less than 1300°C. Thereby, dependency of the film thickness of oxide film 40 on plane orientation of the surface of trench 15 can be reduced further effectively. In addition, in this step (S60), substrate 30 may be heated at a temperature of not more than 1400°C. Thus, the step (S60) can be performed at an appropriate temperature of not less than 1250°C and not more than 1400°C which considers durability of manufacturing equipment and the like.

Next, a nitrogen atoms introduction step is performed as a step (S70). In this step (S70), nitrogen atoms are introduced into a region including an interface between oxide film 40 and silicon carbide constituting substrate 30, by heating substrate 30 in an atmosphere including a gas containing nitrogen atoms. Although this step (S70) is not mandatory, by performing this step, an interface state existing in the region including the interface between oxide film 40 and silicon carbide constituting substrate 30 can be reduced. Accordingly, a reduction in channel mobility due to the existence of the interface state can be suppressed. As the gas containing nitrogen atoms, for example, NO (nitric oxide), NO₂ (nitrogen dioxide), N₂O (nitrous oxide), or the like may be used.

Next, a gate electrode formation step is performed as a step (S80). In this step (S80), referring to Fig. 8, a polysilicon film is formed within trench 15, for example, by a LPCVD (Low Pressure Chemical Vapor Deposition) method. Thereby, gate electrode 41 is formed to be in contact with oxide film 40 formed in the region including the surface of trench 15.

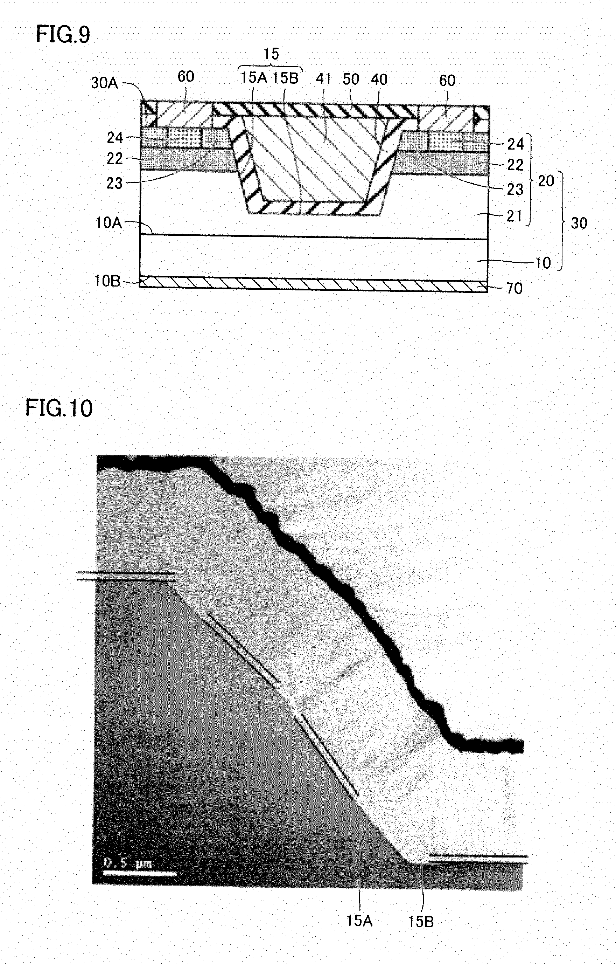

Next, an interlayer insulating film formation step is performed as a step (S90). In this step (S90), referring to Fig. 9, interlayer insulating film 50 made of SiO₂ serving as an insulator is formed, for example, by a P (Plasma)-CVD method, to surround gate electrode 41 together with oxide film 40.

Next, an ohmic electrode formation step is performed as a step (S100). In this step (S100), referring to Fig. 9, firstly, in a region where source electrode 60 is to be formed, interlayer insulating film 50 and oxide film 40 are removed to expose source region 23 and contact region 24. Then, for example, a film made of Ni is formed in the region. On the other hand, for example, a film made of Ni is formed on main surface 10B of silicon carbide substrate 10 opposite to its surface where drift region 21 is formed. Thereafter, alloy heating treatment is performed to silicidize at least portions of the films made of Ni, and thereby source electrode 60 and drain electrode 70 are each formed.

Next, a wire formation step is performed as a step (S110). In this step (S110), referring to Figs. 9 and 1, for example, source wire 61 made of Al serving as a conductor is formed by an evaporation method to cover interlayer insulating film 50 and source electrode 60. On the other hand, backside surface protecting electrode 71 made of, for example, Al is formed to cover drain electrode 70. By performing the above steps (S10) to (S110), MOSFET 1 is manufactured, and the method for manufacturing a semiconductor device in accordance with the present embodiment is completed.

As described above, in the method for manufacturing a semiconductor device in accordance with the present embodiment, oxide film 40 is formed in the region including the surface of trench 15 formed in substrate 30, by heating substrate 30 at an appropriate temperature of not less than 1250°C. Thereby, the dependency of the film thickness of formed oxide film 40 on the plane orientation of the surface of trench 15 is reduced. As a result, even if there are variations in the plane orientation of the surface of trench 15, oxide film 40 having a film thickness close to a desired film thickness can be formed. Thus, according to the method for manufacturing a semiconductor device in accordance with the present embodiment, MOSFET 1 having desired characteristics such as a threshold voltage can be stably manufactured by stably forming oxide film 40 having a desired film thickness in the region including the surface of trench 15.

Although the above embodiment has described the method for manufacturing a trench gate-type MOSFET, the method for manufacturing a semiconductor device in accordance with the present invention is not limited thereto. The method for manufacturing a semiconductor device in accordance with the present invention can be widely used in a method for manufacturing a semiconductor device including the step of forming a thermally-oxidized film in a region including a surface of a trench, such as a method for manufacturing a trench gate-type IGBT (Insulated Gate Bipolar Transistor).

### [Example 1]

An experiment for confirming the effect of the present invention on stable formation of an oxide film in a method for manufacturing a semiconductor device was conducted. Specifically, a trench gate-type MOSFET was manufactured using the method for manufacturing a semiconductor device in accordance with the present embodiment described above. In forming an oxide film, the oxide film was formed in a region including a surface of a trench, by performing heating at 1350°C for 20 minutes in an oxygen atmosphere. Then, a cross sectional structure of the manufactured MOSFET was observed with a BF-STEM (Blight Field-Scanning Transmission Electron Microscope) to investigate a film thickness of the oxide film formed in the region including the surface of the trench in the MOSFET based on an obtained BF-STEM photograph.

The result of the above experiment will be described with reference to Fig. 10. Fig. 10 is a BF-STEM photograph showing a cross sectional structure of the region including the surface of the trench in the MOSFET manufactured in the above experiment (magnification: 50000 times). As is clear from Fig. 10, although side wall surface 15A and bottom surface 15B had significantly different plane orientations, oxide film 40 was formed with a film thickness of about 0.05 µm on each of side wall surface 15A and bottom surface 15B. Thus, it was confirmed that, in the method for manufacturing a semiconductor device in accordance with the present invention, dependency of an oxidation rate on the plane orientation in the formation of the oxide film is reduced, and an oxide film having a desired film thickness can be stably formed.

### [Example 2]

Next, an experiment for confirming, in more details, the effect of the present invention on stable formation of an oxide film in a method for manufacturing a semiconductor device was conducted. Specifically, a trench gate-type MOSFET was manufactured using the method for manufacturing a semiconductor device in accordance with the present embodiment described above. In the step of forming a trench, the trench was formed in a substrate such that its bottom surface corresponded to a (000-1) plane and its side wall surface corresponded to a (0-33-8) plane. Further, in the step of forming an oxide film, the oxide film was formed in a region including the side wall surfaces and the bottom surface of the trench, by performing heating at 1200°C, 1250°C, 1300°C, 1350°C, and 1400°C for 20 minutes in an atmosphere containing oxygen. Then, a film thickness of the oxide film formed in the region including the side wall surfaces and the bottom surface was evaluated to investigate influence of a heating temperature for the substrate on the film thickness of the oxide film. Table 1 shows influence of the heating temperature for the substrate on the film thickness of the oxide film formed in the region including the side wall surfaces and the bottom surface. Table 2 shows influence of the heating temperature for the substrate on a film thickness ratio of the oxide film formed in the region including the side wall surfaces and the bottom surface. Here, the film thickness ratio refers to a ratio of the film thickness of the oxide film formed in a region including the bottom surface to the film thickness of the oxide film formed in a region including the side wall surface.

**[Table 1]**

| | 1200°C | 1250°C | 1300°C | 1350°C | 1400°C |
|---|---|---|---|---|---|
| Film Thickness of Oxide Film (Bottom Surface) (Å) | 146 | 270 | 449 | 659 | 883 |
| Film Thickness of Oxide Film (Side Wall Surface) (Å) | 311 | 447 | 581 | 782 | 970 |

**[Table 2]**

| | 1200°C | 1250°C | 1300°C | 1350°C | 1400°C |
|---|---|---|---|---|---|
| Film Thickness of Oxide Film (Bottom Surface)/ Film Thickness of Oxide Film (Side Wall Surface) (%) | 47 | 60 | 77 | 84 | 91 |

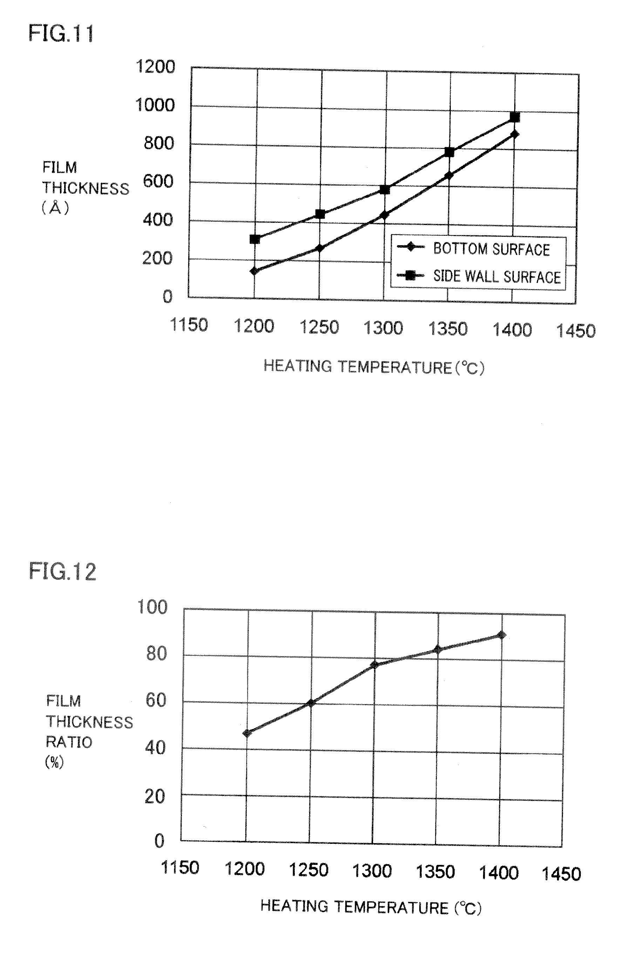

The result of the above experiment will be described with reference to Figs. 11 and 12. Fig. 11 shows the influence of the heating temperature for the substrate on the film thickness of the oxide film formed in the region including the side wall surfaces and the bottom surface. Fig. 12 shows the influence of the heating temperature for the substrate on the film thickness ratio of the oxide film formed in the region including the side wall surfaces and the bottom surface. As is clear from Fig. 11 and Table 1, a difference in film thickness of the oxide film was decreased more with an increase in the heating temperature. Further, as is clear from Fig. 12 and Table 2, when the heating temperature was 1200°C, the film thickness ratio of the oxide film was not more than 50%, whereas when the heating temperature was not less than 1250°C, the film thickness ratio of the oxide film was not less than 50%. Thus, it was confirmed that, in the method for manufacturing a semiconductor device in accordance with the present invention, by setting the heating temperature for the substrate in the formation of the oxide film to not less than 1250°C, preferably not less than 1300°C, the dependency of the oxidation rate on the plane orientation in the formation of the oxide film is reduced, and an oxide film having a desired film thickness can be stably formed.

It should be understood that the embodiment and examples disclosed herein are illustrative and non-restrictive in every respect. The scope of the present invention is defined by the scope of the claims, rather than the description above, and is intended to include any modifications within the scope and meaning equivalent to the scope of the claims.

### INDUSTRIAL APPLICABILITY

The method for manufacturing a semiconductor device and the semiconductor device in accordance with the present invention are particularly advantageously applicable to a method for manufacturing a semiconductor device which is required to stably manufacture a semiconductor device having desired characteristics, and a semiconductor device which is required to stably exhibit a desired withstanding voltage by alleviating electric field concentration on an oxide film.

### REFERENCE SIGNS LIST

1: MOSFET, 10: silicon carbide substrate, 10A, 10B, 30A: main surface, 15: trench, 15A: side wall surface, 15B: bottom surface, 20: silicon carbide layer, 21: drift region, 22: body region, 23: source region, 24: contact region, 30: substrate, 40: oxide film, 41: gate electrode, 50: interlayer insulating film, 60: source electrode, 61: source wire, 70: drain electrode, 71: backside surface protecting electrode.

## Claims

1. A method for manufacturing a semiconductor device, comprising the steps of:
preparing a substrate (30) made of silicon carbide;
forming, in said substrate (30), a trench (15) opened on one main surface (30A) side of said substrate (30); and
forming an oxide film (40) in a region including a surface of said trench (15),
wherein, in the step of forming said oxide film (40), said substrate (30) is heated at a temperature of not less than 1250°C in an atmosphere containing oxygen.

2. The method for manufacturing a semiconductor device according to claim 1, wherein, in the step of forming said oxide film (40), said substrate (30) is heated at a temperature of not less than 1300°C.

3. The method for manufacturing a semiconductor device according to claim 1 or 2, wherein, in the step of forming said oxide film (40), said substrate (30) is heated at a temperature of not more than 1400°C.

4. The method for manufacturing a semiconductor device according to any of claims 1 to 3, further comprising the step of introducing nitrogen atoms into a region including an interface between said oxide film (40) and the silicon carbide constituting said substrate (30), by heating said substrate (30) in an atmosphere including a gas containing nitrogen atoms.

5. The method for manufacturing a semiconductor device according to any of claims 1 to 4, wherein said main surface (30A) of said substrate (30) is a {0001} plane.

6. The method for manufacturing a semiconductor device according to any of claims 1 to 5, wherein, in the step of forming said trench (15), said trench (15) including a wall surface (15A) having an angle of 40° to 70° with respect to a {0001} plane is formed.

7. A semiconductor device (1), comprising:
a substrate (30) made of silicon carbide and having a trench (15) opened on one main surface (30A) side formed therein; and
an oxide film (40) formed to cover a surface (15A, 15B) of said trench (15),
wherein a maximum value of a film thickness of said oxide film (40) is not more than twice a minimum value of said film thickness.

## Amended claims

### Amended claims under Art. 19.1 PCT

1. (Amended) A method for manufacturing a semiconductor device, comprising the steps of:
preparing a substrate (30) made of silicon carbide;
forming, in said substrate (30), a trench (15) opened on one main surface (30A) side of said substrate (30) and including a wall surface (15A) having an angle of not less than 40° and not more than 70° with respect to a {0001} plane; and
forming an oxide film (40) in a region including a said wall surface (15A) of said trench (15),
wherein, in the step of forming said oxide film (40), said substrate (30) is heated at a temperature of not less than 1250°C in an atmosphere containing oxygen.

2. The method for manufacturing a semiconductor device according to claim 1, wherein, in the step of forming said oxide film (40), said substrate (30) is heated at a temperature of not less than 1300°C.

3. The method for manufacturing a semiconductor device according to claim 1 or 2, wherein, in the step of forming said oxide film (40), said substrate (30) is heated at a temperature of not more than 1400°C.

4. The method for manufacturing a semiconductor device according to any of claims 1 to 3, further comprising the step of introducing nitrogen atoms into a region including an interface between said oxide film (40) and the silicon carbide constituting said substrate (30), by heating said substrate (30) in an atmosphere including a gas containing nitrogen atoms.

5. The method for manufacturing a semiconductor device according to any of claims 1 to 4, wherein said main surface (30A) of said substrate (30) is a {0001} plane.

6. (Cancelled)

7. (Amended) A semiconductor device (1), comprising:
a substrate (30) made of silicon carbide and having a trench (15) formed therein, said trench (15) being opened on one main surface (30A) side and including a wall surface (15A) having an angle of not less than 40° and not more than 70° with respect to a {0001} plane; and
an oxide film (40) formed to cover a said wall surface (15A) of said trench (15),
wherein said oxide film (40) is formed by heating said substrate (30) at a temperature of not less than 1250°C, and
a maximum value of a film thickness of said oxide film (40) is not more than twice a minimum value of said film thickness.
